# EUROPÄISCHE PATENTSCHRIFT

(11) **EP 0 720 789 B1**
(45) Veröffentlichungstag und Bekanntmachung des Hinweises auf die Patenterteilung: **03.11.1999**
(21) Anmeldenummer: 94926935.1
(22) Anmeldetag: 13.09.1994
(51) Int. Cl.: H03K 5/08

(54) **SCHALTUNG ZUR STEUERUNG MIT MEHREREN SENSOREN**
DRIVING CIRCUIT WITH SEVERAL SENSORS
CIRCUIT DE COMMANDE A CAPTEURS MULTIPLES

(30) Priorität: 20.09.1993 DE 4331742; 30.09.1993 DE 4333465; 11.10.1993 DE 4334480; 24.11.1993 DE 4340086
(43) Veröffentlichungstag der Anmeldung: 10.07.1996
(60) Teilanmeldung: 99108961.6
(73) Patentinhaber: DEUTSCHE THOMSON-BRANDT GMBH, 78048 Villingen-Schwenningen (DE)
(72) Erfinder: GLEIM, Günter, D-78052 Villingen-Schwenningen (DE); HEIZMANN, Friedrich, D-78052 Villingen-Schwenningen (DE); REKLA, Bernd, D-78052 Villingen-Schwenningen (DE)
(74) Vertreter: Wördemann, Hermes, Dipl.-Ing.
(86) Internationale Anmeldenummer: EP9403050
(87) Internationale Veröffentlichungsnummer: WO9508869

(56) Entgegenhaltungen:
- DE-A- 3 133 703
- US-A- 4 115 715
- US-A- 4 259 662
- US-A- 4 283 664
- US-A- 4 354 145
- US-A- 4 365 187
- US-A- 4 535 294
- US-A- 4 638 197
- US-A- 5 107 135
- US-A- 5 182 500
- PATENT ABSTRACTS OF JAPAN Bd. 17, Nr. 457 (P-1597) 20 August 1993 & JP,A,05 101 561 (FUJITSU LTD) 23 April 1993
- PATENT ABSTRACTS OF JAPAN, Band 11, Nr. 70 (E-485) , 03-03-1987 & JP 61-224900 A

## Beschreibung

Die Erfindung geht aus von einer Schaltung zur Steuerung mit mehreren Sensoren gemäß dem Oberbegriff des Anspruchs 1. Eine derartige Schaltung ist bekannt durch die EP-B1-0 351 697 und wird z.B. verwendet zur Kommutierung oder Geschwindigkeitsregelung des Capstanmotors in einem Videorecorder.

Als Sensoren für die jeweilige Winkelstellung des Rotors können Hallelemente verwendet werden. Diese haben einen großen Ausgangsspannungsbereich. Der Ausgangsspannung eines derartigen Elementes sind jedoch Störungen überlagert, die unter anderem von den Motorspulen direkt magnetisch ausgesprochen werden. Derartige Störungen sind unter Berücksichtigung aller Toleranzen größer als die kleinste Signalspannung. Aus diesem Grunde ist eine einfache Lösung, z.B. die Störungen mittels einer Schwellspannung oder Hysterese herauszufiltern, nicht oder nur bedingt einsetzbar. Auch eine AGC-Schaltung ist nicht anwendbar, da der Motor aus dem Stand heraus sofort richtig starten muß. Eine AGC-Schaltung würde einige Schwingungen im Eingangssignal brauchen, um sich zu stabilisieren.

Der Erfindung liegt die Aufgabe zugrunde, eine Schaltung zu realisieren, die auch in der Lage ist, die genannten Störungen zu unterdrücken, und diese Fähigkeit auch zeitlich unbegrenzt aufrechterhält. Bei Anwendung auf einen Motor soll die Schaltung auch bei Motorstillstand Störungen unterdrücken können.

Aus der US-A-4 535 294 ist eine Schaltung bekannt, bei der die Hysterese eines Komparators von der Amplitude eines erfaßten Sensorsignals gesteuert ist.

Aus der US-A-4 259 662 ist eine Schaltung bekannt, bei der mehrere Sensorsignale erfaßt werden. Das Sensorsignal mit der größten Amplitude wird dazu verwendet, die Schaltschwelle für eine Anzahl von Komparatoren festzulegen.

Diese Aufgabe wird durch die im Anspruch 1 angegebene Erfindung gelöst. Vorteilhafte Weiterbildungen der Erfindung sind in den abhängigen Ansprüchen angegeben.

Die Erfindung beruht auf folgenden Überlegungen und Erkenntnissen. In dem Zeitpunkt, in dem jeweils der Komparator für ein Sensorsignal vor einem Sensor anspricht, also seine Ausgangsspannung sich zwischen den beiden logischen Werten "0" und "1" ändert, ist bekanntlich das dem Komparator zugeführte Sensorsignal in der Nähe von 0. Bei der Erfindung wird nun die Tatsache ausgenutzt, daß die Sensorsignale der anderen Sensoren wegen der Gleichartigkeit und der konstanten Phasenverschiebung eine nennenswerte Amplitude aufweisen. Beispielsweise haben bei einer Anordnung mit drei Sensoren für ein symmetrisches Drehfeld mit 120° Versatz die Sensorsignale jeweils der anderen Sensoren eine Amplitude im Bereich von 86%. Jeweils bei dem Komparator für ein Sensorsignal werden also für die Änderung der Hysterese die Sensorsignale der anderen Sensoren ausgenutzt.

Vorzugsweise werden die Sensorsignale aller Sensoren einer auf die positiven und/oder negativen Spitzenwerte der Sensorsignale ansprechenden ODER-Stufe zugeführt, deren Ausgangsspannung an die die Hysterese bestimmenden Eingänge der Komparatoren angelegt ist. Die ODER-Stufe liefert dann immer das Sensorsignal mit der größten Amplitude.

Es ist dabei auch möglich, eine erste ODER-Stufe für die positiven und eine zweite ODER-Stufe für die negativen Spitzenwerte der Sensorsignale und einen Umschalter vorzusehen, der durch die Ausgangsspannung des Komparators gesteuert ist und den Eingang des Komparators zwischen den Ausgängen der beiden ODER-Stufen umschaltet. Dadurch können eine zur Nullinie symmetrische Hysterese und damit eine bessere Unterdrückung der Störungen erreicht werden.

Vorzugsweise werden jeweils das von einem Sensor kommende Sensorsignal und die Ausgangsspannung der ODER-Stufe an die beiden Eingänge eines Komparators angelegt. Dabei liegt zwischen dem Ausgang der ODER-Stufe und dem zugehörigen Eingang des Komparators jeweils ein Schalter, der durch die Ausgangsspannung des Komparators abwechselnd geöffnet und geschlossen wird.

Bei einer Weiterbildung der Erfindung kann nach der genannten ersten ODER-Stufe noch eine zweite ODER-Stufe für eine zweite Veroderung vorgesehen sein. Dieser zweiten ODER-Stufe werden dann die Ausgangsspannung der ODER-Stufe einer ersten Polarität und die demgegenüber entgegengesetzte Polarität aufweisenden, aber in die erste Polarität transferierten Halbwellen der Ausgangsspannungen der Sensoren angelegt. Dann steht insgesamt eine größere Zahl von Spannungsspitzen zur Verfügung, weil sich dann die Spannungsspitzen von der ersten ODER-Stufe und die in der Polarität umgeklappten Spannungsspitzen abwechseln.

Die Sensoren sind vorzugsweise Hallelemente, die aufgrund eines Magnetfeldes die Kennsignale erzeugen. Die Erfindung ist jedoch auch auf andere Arten von Sensoren, Generatoren und Signalquellen anwendbar.

Die Erfindung wird im folgenden anhand der Zeichnung erläutert. Darin zeigen
- Fig. 1: ein Blockschaltbild für die Auswertung der von den Sensoren erzeugten Signale mit der erfindungsgemäßen Lösung,
- Fig. 2: Kurven zur Erläuterung der Wirkungsweise der Schaltung nach Fig. 1 mit den genannten, in der Polarität geänderten, also ins Positive umgeklappten Spannungsspitzen und
- Fig. 3: eine Abwandlung der Fig. 2 für Sensorsignale unterschiedlicher Amplitude.

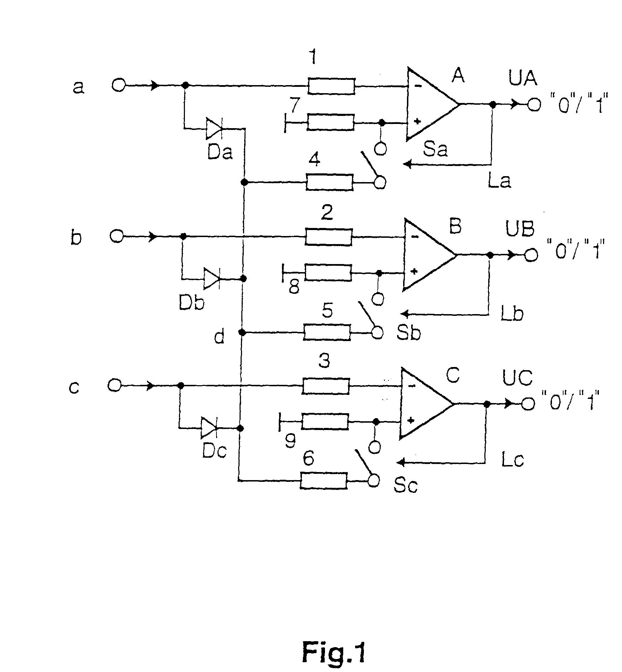

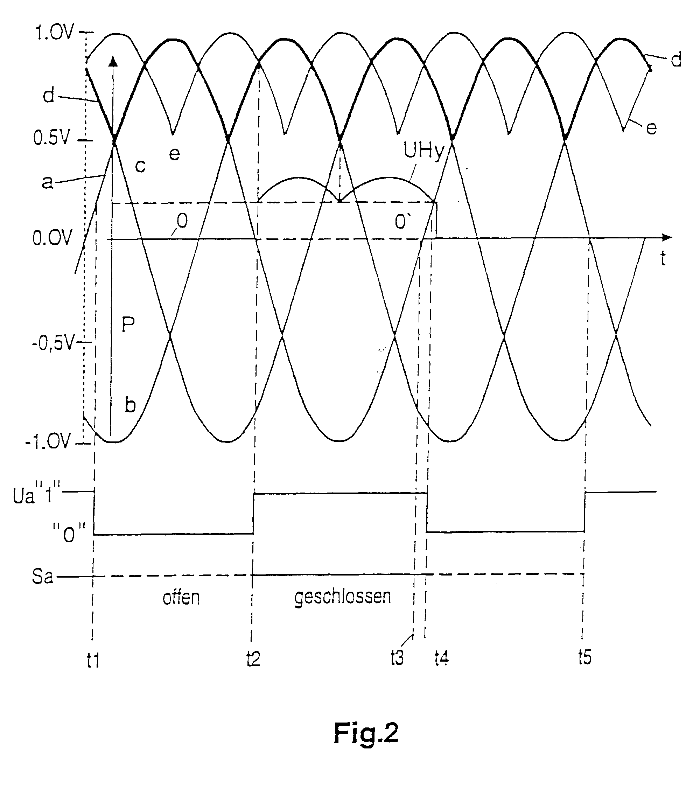

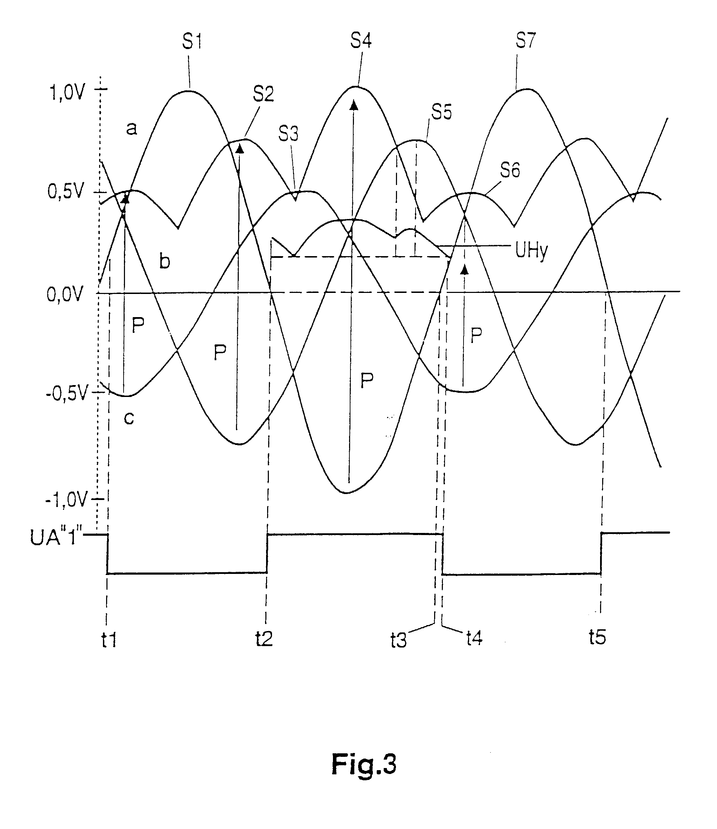

Dabei zeigen die kleinen Buchstaben, an welchen Stellen der Schaltung in Fig. 1 die Signale gemäß Fig. 2, 3 stehen.

Gemäß Fig. 1, 2 werden drei von drei Sensoren kommende, gleichartige, gegeneinander um 120° phasenverschobene Signale a, b, c über die Widerstände 1, 2, 3 jeweils den negativen Eingängen der Komparatoren A, B, C zugeführt. Die Signale a, b, c werden außerdem den eine ODER-Stufe bildenden Dioden Da, Db, Dc zugeführt. Deren Verbindungspunkt d, der den Ausgang der ODER-Stufe bildet, ist jeweils über Widerstände 4, 5, 6 und Schalter Sa, Sb, Sc mit den positiven Eingängen der Komparatoren A, B, C verbunden, die wiederum über Widerstände 7, 8, 9 an einer konstanten Bezugsspannung (Referenz) wie z.B. Erde liegen.

Die Komparatoren A, B, C erzeugen digitale Ausgangsspannungen UA, UB, UC mit den beiden möglichen Zuständen "0" und "1". Diese Spannungen UA, UB und UC steuern außerdem über Leitungen La, Lb, Lc die Schalter Sa, Sb, Sc.

Die Wirkungsweise der Schaltung gemäß Fig. 1 wird anhand der Fig. 2 erläutert. Fig. 2 zeigt die gegeneinander um 120° phasenverschobenen sinusförmigen Sensorsignale a, b, c gleicher Amplitude. Am Punkt d steht jeweils das Signal mit der größten Amplitude. Dadurch ergibt sich für Punkt d der Verlauf gemäß der stark ausgezogenen Kurve. Im folgenden wird die Funktion für das Sensorsignal a am Komparator A erläutert. Bis zum Zeitpunkt t1 liegt das Signal a unter dem Hysteresewert. Da das Signal a an den negativen Eingang des Komparators A gelangt, ist UA im logischen Zustand "1". Dabei ist zunächst angenommen, daß der Schalter Sa geöffnet ist und daher der positive Eingang des Komparators A auf Nullpotential liegt. Im Zeitpunkt tl erreicht das Signal a die Hysteresespannung. Dadurch nimmt UA den Zustand "0" an. Durch die ausgezogene Linie Sa ist angedeutet, daß der Schalter Sa geschlossen ist, und durch die gestrichelte Linie ist angedeutet, daß der Schalter SA geöffnet ist. Von t1-t2 ist somit Sa geöffnet, die Nullinie für das Ansprechen des Komparators A liegt also exakt bei 0 Volt. Im Zeitpunkt t2 geht das Signal a wieder durch die Nullinie und nimmt einen negativen Wert an. Daher ändert sich der Wert von UA wieder von "0" auf "1". Dieser Sprung erfolgt exakt beim Nulldurchgang, weil der Schalter Sa noch geöffnet ist, der positive Eingang des Komparators A auf Nullpotential liegt und daher eine Hysterese nicht wirksam ist. Im Zeitpunkt t2 wird der Schalter Sa geschlossen. Der positive Eingang des Komparators A nimmt daher in Abhängigkeit vom Wert der Widerstände 4 und 7 sowie von der Amplitude des Sensorsignals einen positiven Spannungswert von der Spannung d an. Es kommt daher zu einem Offset in der Nullinie des Komparators A, wie durch die versetzte Nullinie O' dargestellt ist. Die Nullinie, bei der der Komparator A anspricht, ist also jetzt verschoben. Das nächste Ansprechen des Komparators A, als das Umschalten von UA von "1" auf "0", erfolgt also jetzt nicht im Zeitpunkt t3, wo das Signal a die Nullinie kreuzt, sondern dann, wenn das Signal a die versetzte Nulllinie 0' schneidet. Es ist ersichtlich, daß sich dadurch in dem Rückschalten von UA eine einseitige Hysterese ergibt. Einseitig bedeutet, daß der Umschaltpunkt nicht nach + und - verschoben wird, sondern nur nach + Beim Übergang des Signals von + nach - erfolgt also die Umschaltung ideal beim Nullwert, nämlich z.B. bei t2, jedoch beim Übergang von - nach + nicht mehr beim Nullwert, sondern in der beschriebenen Weise verspätet.

Da die Amplitude der Signale a, b, c gleich groß ist, gelten diese Verhältnisse für alle drei Signale a, b, c. Wenn man jetzt für die Hysterese, dargestellt durch UHy, einen bestimmten Prozentsatz vom Sensorsignal annimmt, so wird dadurch erreicht, daß überlagerte Störungen mit einem kleineren Prozentsatz als die Hysterese die Schaltung nicht mehr passieren können, unabhängig von der Amplitude des Sensorsignals.

Die Schaltung kann auch so ausgebildet werden, daß sie auf die negativen Spannungspitzen anspricht, wenn die Dioden Da, Db und Dc umgepolt werden. Dann wäre in Fig. 2 die Nullinie von tl - t2 ins Negative verschoben und im Gegensatz zu Fig. 2 von t2 - t3 exakt bei 0. Es ist auch eine Kombination der Auswertung der positiven und negativen Spitzen möglich. Dann kann eine zur Nullinie symmetrische Hysterese erreicht werden.

Fig. 2 zeigt noch folgende Besonderheit. Die negativen Spitzen des Signals b, die bis -1,0 Volt reichen, sind, wie durch den Pfeil P dargestellt, in der Polarität geändert, also gewissermaßen nach oben umgeklappt. Es ist ersichtlich, daß sich nunmehr die negativen Spitzen des Signals b zwischen die Spitzen der Spannung d am Ausgang der genannten ODER-Stufe legen. Der Vorteil besteht darin, daß nunmehr pro Zeiteinheit mehr Spannungsspitzen verfügbar sind und der Einbruch zwischen den Spannungsspitzen kleiner wird. Bei dieser Anordnung können die Spitzen der Spannung d und die dazwischen liegenden Spitzen der in der Amplitude umgeklappten Spannungen einer weiteren ODER-Stufe zugeführt werden. Dadurch ergibt sich der Vorteil, daß die Hysteresespannung UHy besser geglättet wird, also weniger Einbrüche aufweist. Der Verlauf von UHy entspricht, in der Amplitude entsprechend geteilt, dem Verlauf der Spannung d.

Fig. 3 zeigt drei Sensorsignale, a, b, c, die nicht wie in Fig. 2 gleiche, sondern unterschiedliche Amplituden haben. Das Signal a hat 100%, b etwa 75% und c etwa 50% der Maximalamplitude. Auch in Fig. 3 sind, wie anhand von Fig. 2 beschrieben, die negativen Spitzen aller Signale a, b, c, wie durch die Pfeile P dargestellt, nach oben geklappt. Die negative Polarität wird durch eine Schaltung zur Polaritätsumkehr in die positive Polarität umgewandelt. Abwechselnd folgen aufeinander die original positive Spitze S1 des Signals a mit 100% Amplitude, die in Positive umgeklappte Spitze S2 des Signals b, die original positive Spitze S3 des Signal c, die umgeklappte Spitze S4 des Signals a, die original positive Spitze S5 des Signals b, die umgeklappte negative Spitze S6 des Signals c, die original positive Spitze S7 des Signals a usw. Die dargestellte Hysteresspannung UHy folgt entprechend in der Amplitude geteilt nacheinander den Kurven mit den Spitzen S2, S4, S5. Es ist ersichtlich, daß bei derartigen Signalen mit unterschiedlicher Amplitude das Umklappen der negativen Signalspitzen in den positiven Bereich zusätzliche Spitzen bringt und die Einbrüche zwischen den Spitzen verringert werden. Hinsichtlich der Änderung der Hysterese durch die Spannung am Ausgang der ODER-Stufe würde die Schaltung gemäß Fig. 1 mit dem Signal gemäß Fig. 3 auch in der beschriebenen Weise arbeiten.

## Patentansprüche

1. Schaltung zur Steuerung mit mehreren Sensoren, die mehrere gleichartige gegeneinander phasenverschobene Sensorsignale (a, b, c) erzeugen, die jeweils dem ersten Eingang jeweils eines Komparators (A, B, C) zugeführt werden, **dadurch gekennzeichnet**, daß Schaltungselemente (Da, Db, Dc) vorgesehen sind, die bewirken, daß das größte positive und/oder negative Sensorsignal (a) über jeweils ein Schaltmittel (Sa) dem zweiten Eingang jedes Komparators (A) abhängig von dem Ausgangssignal (La) des jeweiligen Komparators (A) derart zugeführt wird, daß in einem ersten Schaltzustand des jeweiligen Schaltmittels (Sa) der zweite Eingang des jeweiligen Komparators (A) auf ein erstes Potential geschaltet ist und daß, zur Erzeugung einer Hysterese, in einem zweiten Schaltzustand des jeweiligen Schaltmittels (Sa) der zweite Eingang des jeweiligen Komparators (A) auf ein zweites Potential geschaltet ist, das von der Amplitude eines oder mehrerer der den anderen Komparatoren (B, C) zugeordneten Sensorsignalen (b, c) bestimmt ist.

2. Schaltung nach Anspruch 1, **dadurch gekennzeichnet**, daß die Sensorsignale (a, b, c) einer auf die positiven und/oder negativen Sensorsignale ansprechenden ODER-Stufe (Da, Db, Dc) zugeführt sind, deren Ausgangsspannung (d) an die die Hysterese bestimmenden zweiten Eingänge der Komparatoren (A, B, C) angelegt ist.

3. Schaltung nach Anspruch 2, **dadurch gekennzeichnet**, daß jeweils zwischen dem Ausgang der ODER-Stufe und dem zweiten Eingang jedes Komparators (A, B, C) jeweils ein Schaltmittel (Sa, Sb, Sc) liegt, das durch die Ausgangsspannung (UA, UB, UC) des zugeordneten Komparators (A, B, C) betätigt ist.

4. Gerät mit einem Elektromotor, **dadurch gekennzeichnet**, daß eine Schaltung nach einem oder mehreren der Ansprüche 1 bis 3 zur Steuerung des Elektromotors vorgesehen ist.

## Claims

1. Control circuit having a plurality of sensors which produce a plurality of identical, mutually phase-shifted sensor signals (a, b, c) which are each supplied to the first input of in each case one comparator (A, B, C), **characterized** in that circuit elements (Da, Db, Dc) are provided which result in the largest positive and/or negative sensor signal (a) being supplied via in each case one switching means (Sa) to the second input of each comparator (A) depending on the output signal (La) of the respective comparator (A), in such a manner that, when the respective switching means (Sa) is in a first switching stage, the second input of the respective comparator (A) is connected to a first potential, and such that, in order to produce hysteresis, when the respective switching means (Sa) is in a second switching state, the second input of the respective comparator (A) is connected to a second potential, which is governed by the amplitude of one or more of the sensor signals (b, c) which are associated with the other comparators (B, C).

2. Circuit according to Claim 1, **characterized** in that the sensor signals (a, b, c) are supplied to an OR stage (Da, Db, Dc) which responds to the positive and/or negative sensor signals and whose output voltage (d) is applied to the second inputs of the comparators (A, B, C), which inputs determine the hysteresis.

3. Circuit according to Claim 2, **characterized** in that a respective switching means (Sa, Sb, Sc), which is operated by the output voltage (UA, UB, UC) of the associated comparator (A, B, C), is in each case located between the output of the OR stage and the second input of each comparator (A, B, C).

4. Appliance having an electric motor, **characterized** in that a circuit according to one or more of Claims 1 to 3 is provided in order to control the electric motor.

## Revendications

1. Circuit de commande à plusieurs capteurs qui produisent plusieurs signaux de capteur (a, b, c) déphasés équivalents, acheminés respectivement à la première sortie d'un comparateur (A, B, C), **caractérisé en ce qu**'il est prévu des éléments de commutation (Da, Db, Dc) qui entraînent un acheminement du plus important signal positif et/ou négatif sur le dispositif de commutation (Sa) à la deuxième entrée de chaque commutateur (A), indépendamment du signal de sortie (La) du comparateur (A), de telle manière que, dans un premier état de commutation du dispositif de commutation (Sa), la deuxième entrée du comparateur (A) est commutée à un premier potentiel et que, pour produire une hystérèse, dans un second état de commutation du dispositif de commutation (Sa), la deuxième entrée du comparateur (A) est commutée sur un deuxième potentiel qui est déterminé par l'amplitude d'un ou de plusieurs des signaux de capteur (b, c) associés aux autres comparateurs (B, C).

2. Circuit conforme à la revendication 1, **caractérisé en ce que** les signaux de capteur (a, b, c) sont acheminés à un étage OU (Da, Db, Dc), dont la tension de sortie (d) est appliquée aux deuxièmes entrées définies des compensateurs (A, B, C), réagissant aux signaux de capteur positifs et/ou négatifs.

3. Circuit conforme à la revendication 2, **caractérisé en ce qu**'un dispositif de commutation (Sa, Sb, Sc), activé par la tension de sortie (UA, UB, UC) du comparateur associé (A, B, C), est situé entre la sortie de l'étage OU et la deuxième entrée de chaque comparateur (A, B, C).

4. Appareil équipé d'un moteur électrique, **caractérisé en ce qu**'un circuit conforme à une ou plusieurs des revendications 1 à 3 est prévu pour commander le moteur électrique.
